# EUROPEAN PATENT APPLICATION

(11) **EP 4 571 842 A1**
(43) Date of publication of application: **18.06.2025**
(21) Application number: 23215893.1
(22) Date of filing: 12.12.2023
(51) Int. Cl.: H01L 29/40

(54) **SEMICONDUCTOR DEVICE AND METHOD OF FABRICATING A SEMICONDUCTOR DEVICE**

(71) Applicant: Infineon Technologies Austria AG, 9500 Villach (AT)
(72) Inventor: HUTZLER, Michael, 9500 Villach (AT); BREYMESSER, Alexander, 9500 Villach (AT)
(74) Representative: Infineon Patent Department

(57) **Abstract**

In an embodiment, a semiconductor device is provided that comprises a transistor device. The transistor device comprises one or more trenches formed in a first major surface of a semiconductor substrate. Each of the one or more trenches comprises a base and a side wall extending from the base to the first major surface, wherein the side wall comprises an upper section, a lower section, and an intermediate section located between the lower section and the upper section. A field plate is located in the trench and a field dielectric is located on the base and the sidewall of the trench. In the upper section of the sidewall, the field dielectric has a first thickness and in the lower section of the sidewall, the field dielectric has a second thickness that is greater than the first thickness. In the intermediate region of the sidewall, a thickness of the field dielectric changes from the first thickness at a first boundary between the upper section and the intermediate section to the second thickness at a second boundary between the lower section and the intermediate section. A surface of the field dielectric has a concave form at the first boundary between the upper section and the intermediate section and a convex form at the second boundary between the lower section and the intermediate section. The second boundary is edgeless.

## Description

### BACKGROUND

Transistors used in power electronic applications may be fabricated with silicon (Si) semiconductor materials. Common transistor devices for power applications include Si CoolMOSO, Si Power MOSFETs, and Si Insulated Gate Bipolar Transistors (IGBTs).

A transistor device for power applications may be based on the charge compensation principle and may include an active cell field including a plurality of trenches, each including a field plate for charge compensation. In some designs, the trenches and the mesas that are formed between adjacent trenches may have an elongate striped structure. In some other designs the trenches and field plates may have a columnar, needle-like shape.

Further improvements would be desirable to further improve the performance of transistor devices with field plates, for example by reducing the on-state resistance RDS(on).Area.

### SUMMARY

In an embodiment, a semiconductor device is provided that comprises a transistor device. The transistor device comprises one or more trenches formed in a first major surface of a semiconductor substrate. Each of the one or more trenches comprises a base and a side wall extending from the base to the first major surface, wherein the side wall comprises an upper section, a lower section, and an intermediate section located between the lower section and the upper section. A field plate is located in the trench. A field dielectric is located on the base and the sidewall of the trench and has a surface. In the upper section of the sidewall, the field dielectric has a first thickness and in the lower section of the sidewall, the field dielectric has a second thickness that is greater than the first thickness. In the intermediate region of the sidewall, a thickness of the field dielectric changes from the first thickness at a first boundary between the upper section and the intermediate section to the second thickness at a second boundary between the lower section and the intermediate section. The surface of the field dielectric has a concave form at the first boundary between the upper section and the intermediate section and a convex form at the second boundary between the lower section and the intermediate section. The second boundary is edgeless.

In an embodiment, a method of fabricating a field plate in a trench is provided. The semiconductor device comprises at least one trench in a first major surface of a semiconductor substrate, the at least one trench having a base and a side wall extending from the base to the first major surface. The method comprises forming a field dielectric over the base and side wall of the at least one trench, implanting species into a first section of the field dielectric arranged on the side wall, etching the field dielectric at at least the first section, and inserting conductive material into the at least one trench to form a field plate.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 includes figures 1A to 1D, whereby Figures 1A and 1B illustrate cross-sectional views of a semiconductor device which comprises a transistor device having a structured field dielectric in a trench, figure 1C illustrates a comparison transistor device and figure 1D illustrates cross-sectional view of a semiconductor device which comprises a transistor device having a structured field dielectric and a gate electrode in a trench.
Figure 2 illustrates embodiments in which the thickness of the field dielectric in a trench of a transistor device is laterally nonuniform.
Figure 3, which includes figures 3A to 3E, illustrates embodiments of a transistor device, whereby figure 3A illustrates a top view, figure 3B a cross-sectional view along the line A-A shown in figure 3A according to a first embodiment, figure 3C a cross-sectional view along line A-A shown in figure 3A according to a second embodiment, figure 3D a cross-sectional view along the line B-B of the embodiment illustrated in figure 3C and figure 3E a cross-sectional view along the line C- C' of the embodiment illustrated in figure 3C.
Figure 4, which includes figures 4A to 4F, illustrates a method for fabricating a field dielectric in a trench in a semiconductor device.
Figure 5A illustrates an example of a method in which an implantation of the field dielectric in a trench is carried out at two tilt angles.
Figure 5B illustrates an example of a method in which an implantation of the field dielectric in a trench is carried out at more than two tilt angles.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The Figures illustrate relative doping concentrations by indicating "-" or "+" next to the doping type "n" or "p". For example, "n⁻" means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

One type of MOSFET device comprises a compensation element including a vertical trench in silicon and a vertical electrically conductive electrode, also known as a field plate, located in the trench and isolated by a field dielectric from the silicon. The field plate may be formed of polysilicon and the field dielectric may be a field oxide (FOX) such as SiO₂. The field dielectric lines the base and side wall of the trench and typically has a constant thickness on the side wall in vertical and lateral directions.

A thinner field dielectric in the top portions of the trench as well as thicker field dielectric portions in the bottom part of the trench may allow for an increase of doping in the top mesa portions, while sustaining blocking capability. This vertical structuring of the field dielectric within the trench leads to a significant performance gain.

According to an aspect of the present disclosure is proposed herein to further improve the performance of such transistor devices by providing a field dielectric structure which avoids sharp abrupt changes in thickness. According to a further aspect of the present disclosure is proposed herein to fabricate such a field dielectric structure using damage implantation to form smooth curved transitions between regions of differing thickness.

For example, damage implantation into the field dielectric layer that lines the side wall of needle-shaped trenches or elongated stripe-like trenches may be used to increase the wet chemical etch rate in certain lateral directions and/or vertical depths, i.e. to locally increase the wet chemical etch rate in predetermined areas in at least one of the vertical and lateral direction.

In the vertical direction, the damage implantation together with wet etching can be used to fabricate a field dielectric with one or more discrete regions of differing thickness with a smoother, less abrupt transition between them or to fabricate a field dielectric with a continuous taper, i.e. monotonic reduction, in the thickness of the field dielectric.

In lateral directions, the damage implantation together with wet etching may be used to form a laterally anisotropic field dielectric thickness. In some embodiments, this may be used to increase compensation efficiency in the diagonals of needle trenches arranged in a grid (e.g., a square grid), or to form a thicker field dielectric at the ends of stripe trenches, for example.

Damage implantation and the subsequent preferential etching of some regions of the field dielectric over other non-damaged regions may be used to structure the field dielectric and selectively reduce the thickness in some regions in the vertical direction and in the lateral plane.

In an embodiment a method for vertical structuring of the field dielectric located on the side walls of needle or stripe trenches is provided which includes the following. Optionally, the thickness of the deposited field dielectric is increased by some nanometres, e.g. 200 nm to ensure a sufficient thickness of the field dielectric on the base of the trench after the etch process. In some examples, the field dielectric on the base of the trench may be increased after a damage implant and/or etch sequence. The planar thickness of the field dielectric is measured and then a tilted damage implant (e.g., with Argon ions) is carried out, into a region of the field dielectric located on the side wall of the trench, typically a region on the upper section of the side wall. Other regions of the field dielectric are not implanted and are undamaged. After implantation is completed, the field dielectric may be etched using wet or plasma chemistry. In some examples, the measured thickness may be used for etch time adjustment. Optionally several deposition/implant/etch sequences could be repeated to optimize bottom oxide consumption, sidewall thickness, transition point, anisotropy. Since the damaged implanted region has a higher etch rate, a larger portion of the field dielectric material may be removed in this region. This may reduce the thickness of the remaining field dielectric (such as the remaining field dielectric of the region where the damage implantation was performed) over the thickness of the field dielectric that was not subjected to implantation. Like that, two discrete regions of the field dielectric of differing thickness may be created. The method may continue by annealing the field dielectric and filling the trench with conductive material, e.g. polysilicon, to form the field plate.

Alternatively, the field dielectric may be subjected to the damage implantation and etching process(es) and then a further thin field dielectric layer deposited to increase the thickness of the field dielectric by some nanometres, e.g. 200 nm to ensure a sufficient thickness of the field dielectric on the base of the trench. In some embodiments, the sequence of damage implantation, etching and deposition of a further thin field dielectric layer is repeated.

In an embodiment, the tilted damage implant may include N discrete steps that may be created by N discrete implants at different discrete tilt angles. This may be used to fabricate a field dielectric with more than two steps, i.e. more than two regions of differing thickness or a continuously tapered form.

In another embodiment, the tilted damage implant may include N discrete steps that are created by N discrete implants at different discrete tilt angle using the desired rotational angle or angles. For example, rotational angles of 90° and 270° to implant into the opposing long side walls of a stripe trench or 45°, 135°, 225° and 315° so as to implant along the diagonals of a square grid array of columnar trenches. After implantation is completed, the field dielectric is etched using wet or plasma chemistry using the measured thickness for etch time adjustment.

In an embodiment of vertical structuring, a continuous taper is created in the field dielectric by using a high number of discrete implants of different tilt angle and/or energy. This high number of discrete implants may be carried out at one or more desired rotational angles such as rotational angles of 90° and 270° to implant into the opposing long side walls of a stripe trench or 45°, 135°, 225° and 315° so as to implant along the diagonals of a square grid array of columnar trenches. After implantation is completed, the field dielectric is etched using wet or plasma chemistry using the measured thickness for etch time adjustment. Optionally several deposition/implant/etch sequences could be repeated to optimize bottom oxide consumption, sidewall thickness, transition point, anisotropy.

The method continues by annealing the field dielectric and filling the trench with conductive material, e.g. polysilicon, to form the field plate.

The dependency of the area specific capacitance on rotational angle can be used to strengthen the charge compensation in the diagonal direction of the square grid array which has a wider mesa compared to the width of the mesa in the normal directions.

In an embodiment, a method for lateral structuring of the field dielectric located on the side walls of needle or stripe trenches is provided which includes the following. The damage implant is applied in distinct rotational angles only. The field dielectric is anisotropically damaged and subsequently anisotropically etched in the lateral plane. This embodiment may be used in needle trenches, arranged in a square grid pattern to reduce the field dielectric thickness in diagonal direction, e.g. at 45° to the x and y directions, while retaining a greater field dielectric thickness in the normal directions, e.g. in the x and y directions.

In some embodiments, using elements for implantation which are heavier than Argon, e.g. Platinum may be used. This may be used to adjust the damage depth profile to application needs, while reducing unwanted sidewall reflections and bottom oxide thinning.

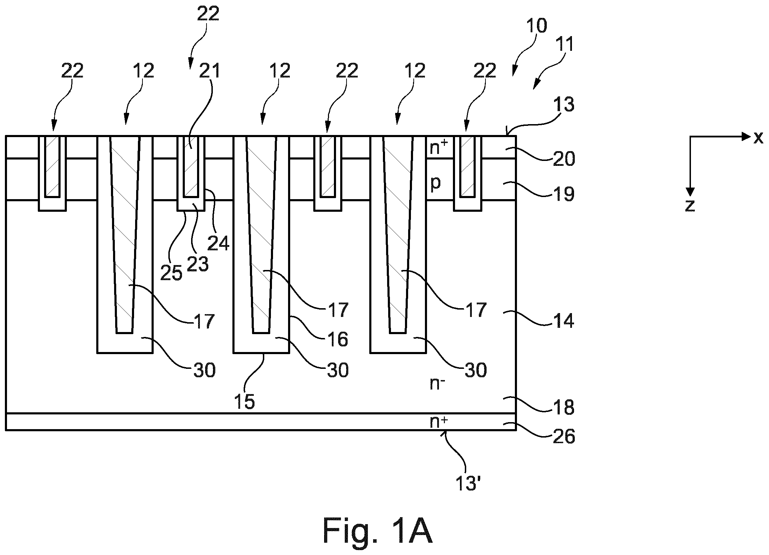

Figure 1A illustrates a cross-sectional view of a semiconductor device 10 according to an embodiment of the present disclosure which comprises a transistor device 11. The transistor device 11 comprises one or more trenches 12 which are formed in a first major surface 13 of a semiconductor substrate 14. The semiconductor substrate 14 may comprise silicon, for example, an epitaxial silicon layer or a monocrystalline silicon substrate, e.g. a wafer or chip. Each trench 12 comprises a base 15 and a sidewall 16 which extends from the base 15 to the first major surface 13. A field plate 17 is located in each trench 12.

The transistor device 11 further comprises a drift region 18 of a first conductivity type which is formed in the semiconductor substrate 14, a body region 19 which is located on the drift region 18 and a source region 20 arranged on the body region 19. The body region 19 comprises a second conductivity type which opposes the first conductivity type. The source region 20 comprises the first conductivity type and is more highly doped than the drift region 18. The first conductivity type may be n-type and the second conductivity type p-type or vice versa. The transistor device 11 further comprises a gate electrode 21 which is arranged in a gate trench 22 formed in the first major surface 13 of the semiconductor device 14 and which is electrically insulated from the semiconductor substrate 14 by a gate dielectric 23 which is arranged on the sidewall 24 and base 25 of the gate trench 22. A drain region 26, which is highly doped with the first conductivity type, is arranged at a second major surface 13' of the semiconductor substrate 14 which opposes the first major surface 13. The trenches 22 comprising gate electrodes 21 are arranged laterally between and spaced apart from the trenches 12 comprising field plates 17.

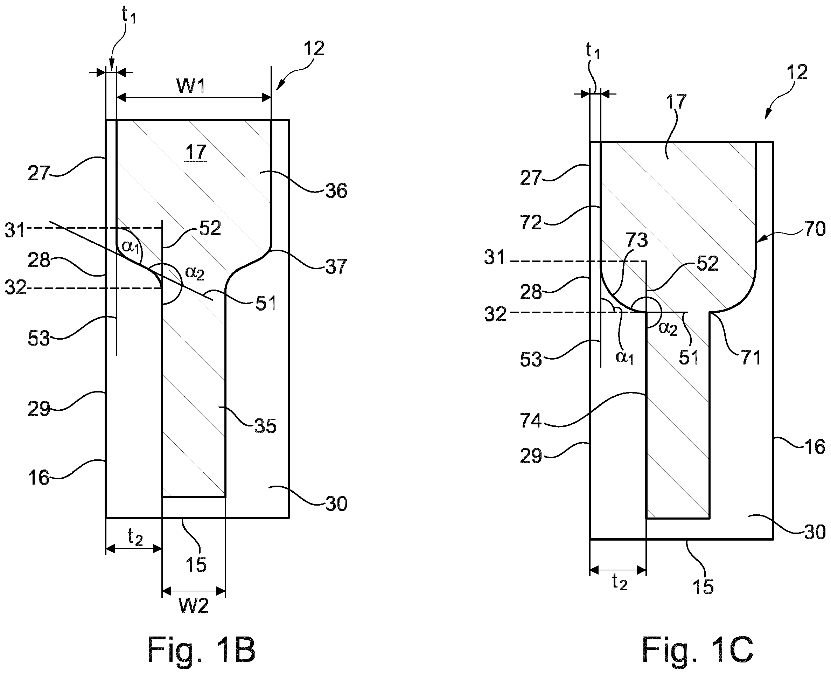

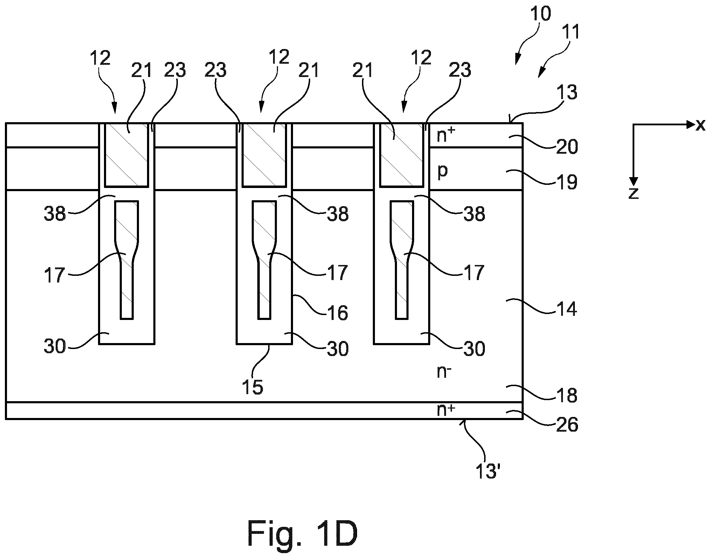

In top view, the gate trenches 22 may be elongate and stripe -like and have a longest direction which extends into the plane of the drawing. The trenches 12 in which the field plate 17 are located may have an elongate stripe-like structure and have a longest direction which extends into the plane of the drawing or may have a columnar structure. The cross-sectional profile shown in figure 1 is the same for columnar trenches and stripe-like trenches.

An elongate or stripe -like trench 12, 22 has a length which extends parallel to the first major surface, its length being greater than its depth from the first major surface and which is in turn greater than its width. The gate electrode 21 or field plate 17 within the trench 12, 22, respectively, also has an elongate stripe-like form having a length which extends parallel to the first major surface 13, its length being greater than its depth from the first major surface 13 and which is in turn greater than its width.

A columnar or needle-shaped trench 12 has a small or narrow circumference or width in proportion to its height / depth in the substrate. A columnar or needle trench 12 may have an octagonal, circular, square, hexagonal shape in plan view. The field plate 17 in the columnar trench 12 also has a small or narrow circumference or width in proportion to its height / depth in the substrate 14. The columnar trenches 12 and consequently the columnar field plates 17 positioned in the respective trenches 12 may be arranged in a regular array, e.g. a square grid array of rows and columns.

In embodiments, in which the trench 12 and field plate 17 are columnar, the columnar trench 12 has a longitudinal axis L which extends substantially perpendicularly to the first major surface 13.

In some embodiments, the transistor device 11 has a drift path that is perpendicular to the major surface 13 of the semiconductor substrate 14 and can be referred to as a vertical transistor device. For example, the transistor device 11 may be a MOSFET (Metal Oxide Semiconductor Field Effect Transistor) device.

A field dielectric 30 is located on and entirely covers the base 15 and sidewall 16 of the trench 12. The field plate 17 is electrically insulated from the semiconductor substrate 14 by the field dielectric 30. The field dielectric 30 may comprise silicon oxide, for example SiO₂, and the field plate 17 may be formed of polysilicon.

Figure 1A illustrates an embodiment in which the field dielectric 18 has a monotonically increasing thickness on the side wall 16 of the trench 12 in the vertical direction, that is perpendicular to the first major surface 13 and from the first major surface 13 towards the base 15 of the trench 12. This structured field dielectric 30 enables the doping level of the mesa formed between the trenches 12 to be increased, whilst maintaining the blocking capability of the transistor device 11 and allow the performance of the transistor device 11 to be increased.

Figure 1B illustrates an enlarged view of a trench 12 including a field plate 17 and a field dielectric 30 according to another embodiment. This embodiment of the field dielectric 30 and field plate 17 may be used in the transistor device 11 illustrated in figure 1A in place of the field dielectric 30 and field plate 17 shown in figure 1A. In this embodiment, the field dielectric 30 is structured to have two regions of differing thickness. The sidewall 16 of the trench 12 has an upper section 27, an intermediate section 28 and a lower section 29, the intermediate section 28 being arranged between the upper section 27 and the lower section 29. The upper section 27 is located adjacent to the first major surface 13 and the lower section 29 extends from the base 15 of the trench 12.

The side wall 16 may have subsections depending on the lateral shape of the trench 12. For example, a circular columnar trench has a single side wall 16, whereas an elongate trench that is rectangular in plan view has four side wall sections arranged perpendicularly to one another.

In an embodiment, in the upper section 27 of the sidewall 12, field dielectric 30 has a first thickness t1 and in the lower section 29 of the sidewall 12 the field dielectric 30 has a thickness t2 which is greater than the first thickness t1. The difference between the first thickness t1 and the second thickness t2 is greater than that arising from inherent variations in processing conditions and is at least 10%, in other words, the difference between t1 and t2 is at least 10% of the thickness t1 or (t2 - t1)/t1 * 100 ≥ 10%. In another embodiment, (t2 - t1)/t1 * 100 ≥ 20%. The intermediate section 28 of the sidewall represents the vertical difference over which the thickness of the field dielectric 30 increases from the smaller thickness t1 to the greater thickness t2. The first thickness t1 may be the average thickness of the field dielectric 30 located on the upper section 27 and the second thickness t2 may be the average thickness of the field dielectric 30 located on the lower section 29 of the side wall 16. The variation of the thickness t1 is less than 5% of the thickness t1, i.e. 0.95 t1 < t1 < 1.05 t1. The variation of the thickness t2 is less than 5% of the thickness t2, i.e. 0.95 t2 < t2 < 1.05 t2.

Over the vertical distance of the intermediate section 28 of the sidewall 16, the thickness of the field dielectric 30 changes from the first thickness t1 at a boundary 31 formed between the upper section 27 and the intermediate section 28 to the second thickness t2 at a second boundary 32 formed between the lower section 29 and the intermediate section 28. The second boundary 32 is edgeless. In other words, the field dielectric 30 does not include a sharp abrupt change in thickness, that is include an edge, at the lower second boundary 32 between the larger thickness t2 at the bottom of the trench 12 and the reduced thickness of the field dielectric 30 in the intermediate section 28 of the trench. The second boundary 32 is smooth and provides a smooth transition from the first thickness t1 to an increased thickness in the vertical direction, i.e. perpendicular to the first major surface 13, as well as in lateral directions parallel to the first major surface 13. The field dielectric 30 includes a curved form at the second boundary 32. The surface of the field dielectric 30 has a concave form at the first boundary 31 and a convex form at the second boundary 32. The second boundary 32 may have a radius of curvature, for example radius of curvature that lies within the range of 100 nm and 500nm, for example, around 300 nm. The first boundary 31 may have a radius of curvature, for example radius of curvature that lies within the range of 100 nm and 500nm, for example, around 300 nm.

In some embodiments, the concave form extends around the entire circumference of the trench 12 so that the surface of the field dielectric 30 includes a groove having the radius of curvature. In some embodiments, the convex form extends around the entire circumference of the trench 12 so that the surface of the field dielectric 30 includes a ridge having the radius of curvature.

Since the field plate 17 fills the remainder of the trench 12 that is not occupied by the field dielectric 30, the field plate 17 has the complementary profile to the profile of the field dielectric. In the embodiment illustrated in figure 1B, the surface of the field plate 17, therefore, includes a convex form at the first boundary 31 and a concave form at the second boundary 32.

In some embodiments, the first boundary 31 formed between the upper section 27 and the intermediate section 28 is also edgeless. In this embodiment, the transition between the thinner section of the field dielectric 30 in the upper section 27 of the trench and the increasing thickness in the intermediate section 28 is smooth, for example has a curved form and may have a radius of curvature that lies within the range of 100 nm and 500nm, for example, around 300 nm.

As shown in figure 1B, an angle α₂ is formed between the surface of the field dielectric 30 located in the intermediate section 28 of the sidewall 16 and the surface of the field dielectric 30 located in the lower section 29 of the sidewall 16. The angle α₂ is measured between a first line 51, or tangent, located at the point of the surface of the field dielectric 30 which has the greatest gradient within the intermediate section 28 and a second line 52 or tangent located at the point of the surface of the field dielectric 30 which has the greatest gradient within the lower section 29. The angle α₂ is between 180° < α₂ < 270° or 2000° ≤ α₂ ≤ 250°.

As is also shown in figure 1B, an angle α₁ that is formed between the surface of the field dielectric 30 located in the upper section 27 of the sidewall 16 and the surface of the dielectric 30 located in the intermediate section 28 of the sidewall 16. The angle α₁ is measured between a third line 53, or tangent, that is located at the point of the surface of the field dielectric 30 which has the greatest gradient within the upper section 27 and the second line 51 located at the point of the surface of the field dielectric 30 which has the greatest gradient within the intermediate section 28 of the sidewall 16. The angle α₁ is between 90° < α₁ < 180° or 100° ≤ α₁ ≤ 150°.

The field plate 17 fills the remainder of the trench 12 that is not occupied by the field dielectric 30. The field plate 17 is formed of a conductive material, such as poly silicon. The field plate 17 has a lower section 35 which has a width W2 which is less than the width W1 of the upper section 36 that is arranged adjacent the upper sections 27 of the sidewall 16 of the trench 12. The field plate 17 includes an intermediate transition region 37 adjacent the intermediate section 28 of the sidewall 16 of the trench 12 which has an edgeless boundary between the lower section 35 and the intermediate section 37 and which may also have an edgeless boundary between the intermediate section 37 and the upper section 36.

An edgeless shape of the field dielectric 30 at the second boundary 31 and, optionally, also at the first boundary 31, avoids a peak in the electric field and further improves the reliability and performance of the transistor device 11.

The edgeless transition at the second boundary 32 and, if present, at the first boundary 31, can be fabricated by use of a method in which an initial field dielectric layer 30' is formed on the base 15 and the sidewall 16 of the trench which has a substantially uniform thickness from the first major surface 13 to the base 15. Species, e.g. Ar ions are implanted into a region of the initial field dielectric layer 30', for example, into the surface of the initial field dielectric layer 30' positioned on an upper region of the trench 12 to form an upper portion of the initial field dielectric layer 30' which has a damaged structure, due to the implanted ions, and a lower section of the field dielectric 30 which has an undamaged structure, since this lower section was not subjected to ion implantation. In some embodiments, a damaged structure may have a crystal structure with weakened chemical bond strength. The damaged implanted portion has a higher of rate of etching than the undamaged nonimplanted portion in a wet chemical etching process for the same etching time and conditions. Consequently, when the initial field dielectric layer 30' is subsequently subjected to etching, more material is removed in the upper damaged section than in the lower non-damaged section due to the higher etching rate of the damaged field dielectric regions(s) 30' than that of the non-implanted portion for the same etching time and conditions. This results in a field dielectric structure 30 with a smaller thickness t1 in the upper section and a greater thickness t2 in the lower section of the sidewall 16.

As a result of this implantation method, an abrupt transition between implanted and non-implanted regions does not occur. Rather, a smoother transition from a portion of the initial field dielectric layer 30' with a higher ion concentration to a portion with a lower ion concentration is formed. Consequently, the etch rate of the field dielectric 30' varies more smoothly between the implanted and nonimplanted regions. This can be used to form a smooth transition between the smaller thickness t1 and a larger thickness t2 in the vertical direction. An intermediate section 28 is formed in the vertical direction between an upper section 27 adjacent the first major surface 13 in which the field dielectric 30 has the thickness t1 and a lower section 29 which extends from the base 15 in which the field dielectric 30 has the thickness t2. This method results in a first boundary 31 between the upper section 27 and the intermediate section 28 of the field dielectric 30 that is edgeless and a second boundary 32 between the intermediate section 28 and the lower section 27 of the field dielectric 30 that is edgeless and smooth.

In some embodiments, the upper section of the field dielectric 30 that is arranged on the upper section 27 of the sidewall 16 includes ions, for example Ar ions, remaining from the implantation process, whereas the lower section of the field dielectric 30 that is arranged on the lower section 29 of the sidewall 16 comprises a lower concentration of ions and may be free of Ar ions, since ions were not implanted directly into this region. Since a portion of the ions may be reflected from the implantation site, a lower concentration of ions from this reflected portion may be present in other regions outside of the implantation site, for example the lower section of the field dielectric 30 on the side wall and the field dielectric 30 on the base 15 of the trench 12.

In some embodiments, the profile of the field dielectric 30 is laterally substantially uniform, e.g. the field dielectric 30 has a substantially uniform thickness about the longitudinal axis L of a columnar trench 12 or the field dielectric 30 has a substantially uniform thickness about the centre plane of an elongate trench 12, the centre plane extending along the length and perpendicular to the first major surface 13.

Figure 1C illustrates a comparison trench 12 having a field plate 17 and field dielectric 30 on the side all 16 and base 15 of the trench 12. The field dielectric 30 has a comparison field dielectric profile 70 which includes an abrupt step 71 in the field dielectric thickness. In this comparison trench 12, an angle α_{1 =}90° is formed between the between the third line 53, or tangent, that is located at the point of the surface of the field dielectric 30 which has the greatest gradient within the upper section 27 and the second line 51 located at the point of the surface of the field dielectric 30 which has the greatest gradient within the intermediate section 28 of the sidewall 16.

One method for forming the abrupt step-like vertical thickness differences in the field dielectric 30 as shown in the comparison trench 12 of figure 1C comprises: depositing a thick field dielectric on the side wall and base of the trench, filling the trench by depositing a sacrificial material, e.g. Polysilicon, planarization e.g. by chemical mechanical polishing (CMP), removing a portion of the poly silicon to form a recess having a target depth, partial removal of the exposed region of the field dielectric by wet etching only in regions exposed by the recessed sacrificial material, removal of the remainder of the sacrificial material and filling the trench with the structured field dielectric with polysilicon. This method enables the fabrication of a field dielectric 30 on the side wall 16 of the trench 12 with one discrete step in the thickness. This method results in a very abrupt step 71 in the field dielectric surface which leads to an unwanted electrical field peak. As is shown in figure 1C, an angle α₁ is formed between the surface of the field dielectric 30 located on the upper section 72 of the sidewall 16 and the surface of the field dielectric 30 located in the lower section 74 of the sidewall 16. The angle α₁ is measured between a third line 53, or tangent, located at the point of the surface of the field dielectric 30 which has the greatest gradient within the upper section 72 and a second line 51 or tangent located at the point of the surface of the field dielectric 30 which has the greatest gradient within the intermediate section 73. The angle α₁ is 90°. An angle α₂ is formed between the second line 51, or tangent, located at the point of the surface of the field dielectric 30 which has the greatest gradient within the intermediate section 73 and a second line 52 or tangent located at the point of the surface of the field dielectric 30 which has the greatest gradient within the lower section 74. α_{2 =} 270°

In the comparison trench of figure 1C, the angles α_{1 =} 90° and α₂ = 270° are therefore distinguishable from the angles α_{1 and} α₂, respectively, as shown in figure 1B, which are greater than 90° and less than 270° respectively.

Figure 1D illustrates a semiconductor device 10 comprises a transistor device 11 in which the gate electrode 21 is positioned in the same trench 12 as the field plate 17 rather than in a separate gate trench as shown in the embodiment illustrated in figure 1A. The gate electrode 21 is arranged above the field plate 17 within the trench 12 and is electrically insulated from the field plate 17 by an intermediate dielectric layer 38 and from the semiconductor substrate 10 by a gate electric 23 that is located on the upper section of the side wall 16 of the trench 12. In this embodiment, the gate electrode 21 is arranged in the upper section 27 of the trench 12.

The transistor device 11 typically comprises a plurality of trenches 12 which each include a field plate 17. In embodiments in which the trenches 12 and the field plate 17 in the trench are columnar, the trenches 12 and consequently the field plates 17, may be arranged in a regular array, for example a square grid array.

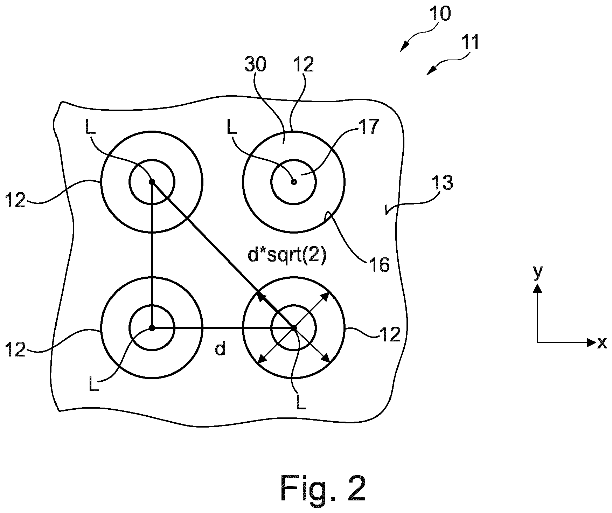

Figure 2 illustrates a top view of a portion of semiconductor device according to an embodiment and illustrates four columnar trenches 12 that are formed in the first major surface 13 of the substrate 14 and that are arranged in a square grid array. The first major surface 13 of the substrate 14 lies in the x-y plane using the Cartesian coordinate system and the depth of the trench 12 and side wall 16 of the trench 12 extends in the z direction using the Cartesian coordinate system. In this example, each trench 12 has a circular form in top view and comprises a columnar field plate 17 with a circular contour. The pitch, that is the centre-to-centre distance between two neighbouring trenches 12 in the x direction and in the y direction is d. The distance between two columnar trenches 12 in a direction of 45° to the x direction and in a direction of 45° to the y direction, which may be referred to as the diagonal direction, is greater than d, namely d V2.

In the embodiment illustrated in figure 2, the thickness of the field dielectric 30 on the sidewall 16 at the first major surface 13 is substantially uniform around the longitudinal axis L. In other words, the thickness of the field dielectric 30 is laterally uniform at the first major surface 13. The thickness of the field dielectric 30 varies in the vertical z direction, that is parallel to the longitudinal axis L. In some embodiments, the thickness of the field dielectric 30 varies in the vertical direction, that is along the height of the sidewall 16, for example according to the embodiments described with reference to figure 1.

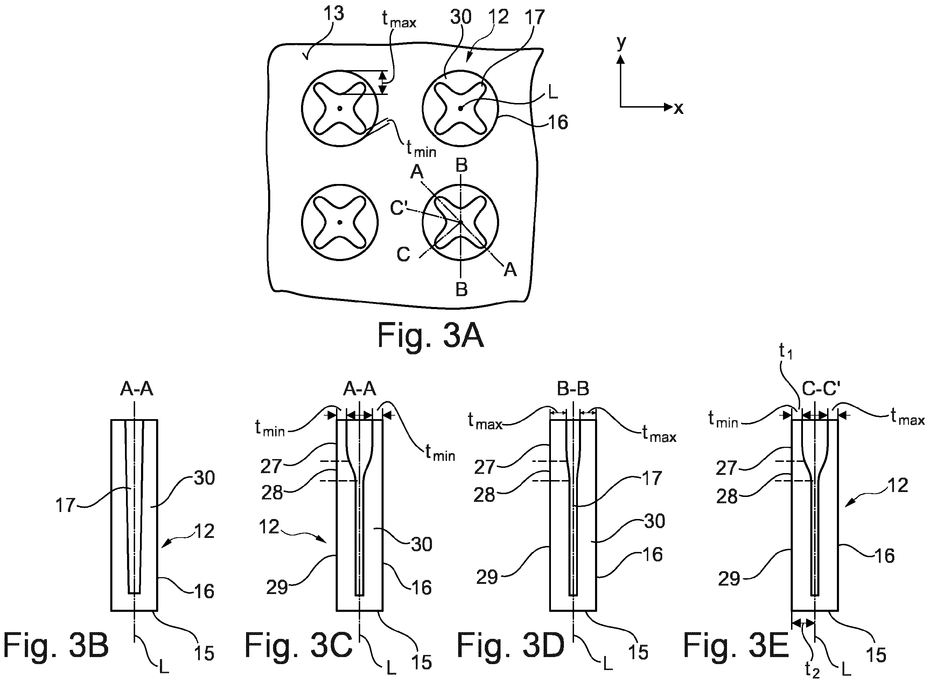

Figure 3 illustrates embodiments of a transistor device 11 including at least one columnar trench including a columnar field plate 17 in which the thickness of the field dielectric 30 is laterally nonuniform and varies around the longitudinal axis L in at least one plane that lies parallel to the first major surface. The sidewall 16 of the columnar trench 12 has a circumference and the thickness of the field dielectric 30 varies at different points along the circumference of the sidewall 16 in at least one plane that lies parallel to the first major surface.

In some embodiments, the thinner thickness t1 of the field dielectric 30 on the upper section 27 of the side wall 16 of the trench 12 laterally is nonuniform and varies around the longitudinal axis L in at least one plane that lies parallel to the first major surface.

The lateral variation in the thickness of the field dielectric 30 on the side wall 16 of the trench 12 may be non-uniform in the vertical direction. For example, the difference between the maximum and minimum lateral thickness varies along the height of the side wall 16. The difference between the maximum and minimum lateral thickness in the intermediate section 28 may be greater than the difference between the maximum and minimum lateral thickness in the upper section 27.

In some embodiments, the thickness t1 of the field dielectric 30 in the upper section 27 varies at different points along the circumference of the sidewall 16 in at least one plane that lies parallel to the first major surface 13 in the upper section.

In some embodiments, the thickness of the field dielectric 30 in the intermediate section 28 varies at different points along the circumference of the sidewall 16 in at least one plane that lies parallel to the first major surface 13 in the intermediate section 28. The variation of the thickness in at least one plane that lies parallel to the first major surface 13 in the intermediate section 28 may be greater than the variation in the thickness in at least one plane that lies parallel to the first major surface 13 in the upper section.

In some embodiments, the variation of the thickness of the field dielectric in at least one plane that lies parallel to the first major surface 13 in the intermediate section 28 may be greater than the variation in the thickness of the field dielectric in at least one plane that lies parallel to the first major surface 13 in the upper section and the variation of the thickness of the field dielectric in at least one plane that lies parallel to the first major surface 13 in the lower section 29 may be greater than the variation in the thickness of the field dielectric in at least one plane that lies parallel to the first major surface 13 in the upper section and less than the variation of the thickness of the field dielectric in at least one plane that lies parallel to the first major surface 13 in the intermediate section 28.

In some embodiments, the second thickness t2 the field dielectric 30 is laterally substantially uniform and is substantially constant around the longitudinal axis in at least one plane that lies parallel to the first major surface 13.

In some embodiments, a combination of a first thickness t1 of the field dielectric 30 that is laterally nonuniform and varies around the longitudinal axis L in at least one plane parallel to the first major surface 13 and a second thickness t2 of the field dielectric 30 that is substantially laterally uniform and substantially constant around the longitudinal axis L in at least one plane that lies parallel to the first major surface 13 is used.

Since the electrically conductive material forming the field plate 17 fills the remainder of the trench 12, the columnar trench 12 comprises a columnar field plate 17 which has a first width w1 in the upper section 27 of the sidewall 16 which varies laterally in a plane that is parallel to the first major surface 13 and around the longitudinal axis L of the trench 12.

The difference between the first thickness t1 and the second thickness t2 is greater than that arising from variations in processing conditions and may be at least 10%, in other words, the difference between t1 and t2 is at least 10% of the thickness t1, i.e. (t2-t1)/t1 * 100 ≥ 10%.

Similarly, in embodiments in which the thickness of the field dielectric 30 varies laterally, that is in at least one plane that is parallel to the first major surface 13 and around the longitudinal axis of the columnar trench 12, the thickness has maximum thickness tₘₐₓ and a minimum thickness tₘᵢₙ and tₘₐₓ ≥ 1.1 tₘᵢₙ. The difference between the maximum thickness tₘₐₓ and the minimum thickness tₘᵢₙ in the at least one plane is greater than that arising from inherent and unavoidable variations in processing conditions.

Figure 3 includes figures 3A to 3E and illustrates an embodiment of the transistor device 11, in which the thickness of the field dielectric 30 varies laterally, i.e. varies in at least one plane that is parallel to the x-y plane of the first major surface 13 and optionally also varies vertically. The transistor device 11 shown in figure 3 has columnar trenches 12, each having a circular shape in top view that are arranged in a square grid array. Four columnar trenches 12 are shown in figure 3A. However, in other non-illustrated embodiments, the columnar trenches 12 of the transistor device 11 may have a shape other than circular in top view, for example, hexagonal or octagonal, and may be arranged in another type of regular array that is not a square grid array, for example non-staggered grid arrays.

Figure 3A illustrates a top view, figure 3B a cross-sectional view along the line A-A shown in figure 3A according to a first embodiment, figure 3C a cross-sectional view along line A-A shown in figure 3A according to a second embodiment, figure 3D a cross-sectional view along the line B-B of the embodiment illustrated in figure 3C and figure 3E a cross-sectional view along the line C- C' of the embodiment illustrated in figure 3C.

As can be seen in the top view of figure 3A, the thickness of the field dielectric 30 in the 45° directions of the square grid array is less than the thickness of the field dielectric 30 in the orthogonal x and y directions of the square grid array. Since the conductive material forming the field plate 17 fills the remainder of the columnar trench 12, the field plate 17 can be considered to have four equally spaced lobes with the peak of each lobe being aligned in the 45° direction. This lateral form is located in at least one plane parallel to the first major surface 13 and may be substantially the same in the vertical direction, i.e. perpendicular to the first major surface, over a certain depth, for example, the upper portion 27 of the side wall 16.

The field dielectric 30 has a minimum thickness tₘᵢₙ that is aligned such that it extends along the 45° directions and a maximum thickness tₘₐₓ that is aligned in the x and y directions. In an embodiment tₘₐₓ ≥ 1.1 tₘᵢₙ. The difference between the maximum thickness tₘₐₓ and the minimum thickness tₘᵢₙ in the at least one plane is greater than that arising from inherent and unavoidable variations in processing conditions. The maximum thickness tₘₐₓ may be the same as or less than the thickness of the field dielectric 30 on the lower section of the side wall 16 of the trench.

In some embodiments, in addition to the lateral variation in the thickness of the field dielectric 30 shown in the top view of figure 3A, the thickness of the field dielectric 30 also varies in the vertical direction. Figures 3B to 3E illustrate cross-sectional views of the trench 12 embodiments in which the thickness of the field dielectric 30 varies in lateral directions as shown in figure 3A and in the vertical direction.

Figure 3B illustrates a cross-sectional view of the plane A-A shown in figure 3A of a trench 12 according to an embodiment in which the thickness of the field dielectric 30 increases monotonically from the first major surface 13 in the direction of the base 15, i.e. increases monotonically in the z direction. In the cross-sectional view along line A-A, the field plate 17 has a funnel-shape and has a greater area at the first major surface 13 than at its base.

In other embodiments, such as that illustrated in figure 3C, the field dielectric 30 has a vertical profile as illustrated in figure 1B in addition to the lateral profile shown in figure 3A.

Figure 3C illustrates a cross-sectional view of the trench 12 in the plane A-A shown in figure 3A along the diagonal 45° direction of the square grid array. The field dielectric 30 has its minimum thickness in this 45° direction, e.g. at the first major surface 13 or in a plane that is substantially parallel to the upper surface 13 and is located in the upper section 27 of the sidewall 16. The field dielectric 30 also includes a section on the upper section 27 of the side wall 16 having a thickness t1 which is smaller than the thickness t2 of the field dielectric 30 on the lower section 29 of the sidewall 16 and has an intermediate or transition section 28 that extends between the upper section 27 and the lower section 29 such that a smooth edgeless transition is provided at the first boundary 31 between the upper section 27 and the intermediate section 28 and at the second boundary 32 between the intermediate section 28 and the lower section 29.

Figure 3D shows a cross-sectional view in the plane B-B shown in figure 3A of the trench 12. The plane B-B extends in the y direction. The field dielectric 30 has its maximum thickness on the sidewall 16 of the trench in the upper section 27.

Figure 3E illustrates a cross-sectional view along the line C-C' shown in figure 3A for the embodiment of figure 3C. The cross-sectional view C-C' extends through the peak of a lobe and between two adjacent lobes. Figure 3E shows the laterally nonuniform thickness of the field dielectric 30 and width of the field plate 17 around the longitudinal axis L. The field dielectric 30 has the thickness tmin the diagonal 45° direction and tmax in the x direction at the first major surface 13.

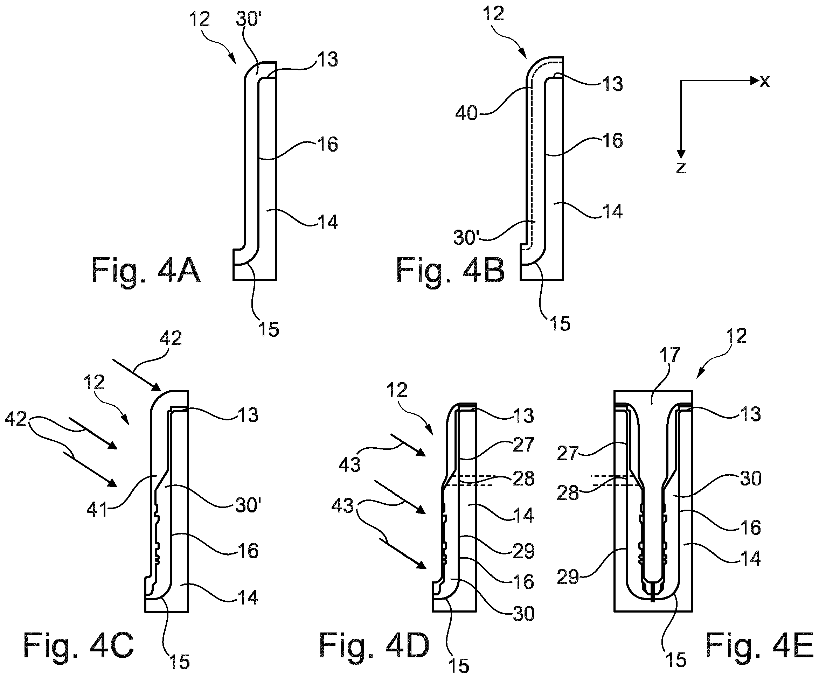

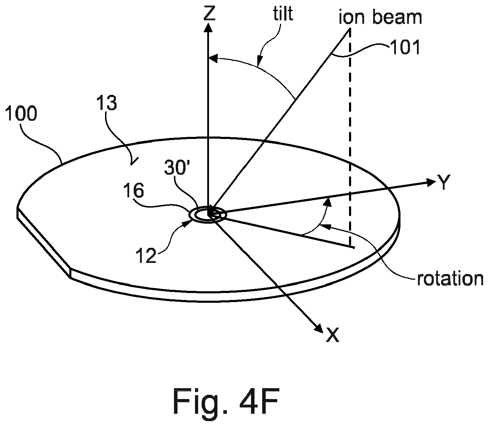

A method for fabricating a field dielectric in a trench in a semiconductor device, e.g. transistor device, will now be described with reference to figure 4, which includes figures 4A to 4F. The method may be used to fabricate the field plate 17 and field dielectric 30 having a form described with reference to and as illustrated in one of figures 1 to 3.

A semiconductor device 10 is provided which comprises at least one trench formed in first major surface 13 of semiconductor substrate 14. Each trench 12 has a base 15 and the sidewall 16 extending from the base 15 to the first major surface 13. The trench 12 may be strip-like or columnar. The semiconductor device 10 may be used to fabricate a transistor device.

Referring to figure 4A, an initial field dielectric layer 30' is formed over the base 15 and sidewall 16 of each of the trenches 12. In some embodiments, as illustrated in figure 4B, a further layer 40 of the material of the initial field dielectric layer 30' may be deposited over the initial field dielectric layer 30' to increase the thickness. Referring to figure 4C, species, such as argon ions, are implanted into a first section 41 of the initial field dielectric 30' and further layer 40 if present, that is arranged on the sidewall 16 of the trench 12 a shown schematically by the arrows 42. In particular, the species may be implanted into an upper section 41 of the field dielectric 30 that is arranged on the sidewall 16 adjacent the first major surface 13. In some embodiments, the species may also be implanted into the portion of the initial field dielectric layer 30' which extends over the first major surface 13. Other regions of the field dielectric layer 30', for example towards the base 15 of the trench 12 are not directly implanted. Species may be reflected from the initial implantation site into other regions, for example into the field dielectric layer 30' on the base 15 of the trench 12 or on opposing sections of the side wall of the trench. These regions into which reflected ions impact include a lower concentration of ions compared to the initial implantation site and, therefore, have a lower etch rate than the initial implantation site.

In an embodiment, before the damage implantation process, a sacrificial material is deposited into the trench 12. An upper portion of this sacrificial material may be removed to form a recess having a certain depth d. This sacrificial material or layer shields the covered regions of the field dielectric at the bottom of the trench from being implanted and leaves other regions, for example on the transition and upper sections of the side wall uncovered so that these uncovered regions of the field dielectric are implanted by the species. After implantation, the remainder of the sacrificial material is removed. In this way, the shielded field dielectric region has no increased etch rate and after the etch process remains thicker compared to the exposed and implanted region(s),

Referring to figure 4D, the field dielectric 30 is then etched, that is at least the section of the initial field dielectric layer 30' into which the species were implanted is etched. A wet chemical etching or plasma etching may be used. The implanted region of the field dielectric layer 30' has a higher etch rate than the non-implanted regions for the same etching conditions. Therefore, the rate of removal of the field dielectric material is greater in the implanted region than in the nonimplanted region so that the thickness reduction is greater in the implanted region than in the nonimplanted region. Therefore, a structured field dielectric 30 with a non-uniform thickness is formed using a single etch process.

Referring to figure 4E, subsequently, electrically conductive material is inserted into the at least one trench 12 to form the field plate 17. The electrically conductive material fills the remainder of the trench 12 that is not occupied by the structured field dielectric 30. Therefore, the contour of the field plate 17 has an outer contour that is complementary to the contour of the surface of the field dielectric 30.

The etching of the field dielectric 30 at at least the first section 41 may result in the formation of field dielectric 30 having the first thickness t1 on the upper section 27 of the sidewall 16 and a second thickness t2 and the lower section 29 of the sidewall, whereby the second thickness t2 is greater than the first thickness t1. The difference between t2 and t1 is greater than the inherent variations arising from processing variations, so that (t2-t1)/t1 * 100 ≥ 10%. In an intermediate region 28 of the sidewall 16, that is arranged between the lower section 28 and the upper section 27, the thickness of the field dielectric 30 changes from the first thickness t1 at first boundary 31 between the upper section 27 and the intermediate section 28 to the second thickness t2 at a second boundary 32 located between the lower section 29 and the intermediate section 28. The second boundary 32 is edgeless and, therefore, smooth. The first boundary 31 may also be edgeless and, therefore, smooth.

The first section 41, into which the species are implanted, has a height, that is a dimension in the z direction that is perpendicular to the first major surface 13, that is less than the height of the field dielectric 30 arranged on the sidewall 16 of the trench 12. In other words, at least a section of the field dielectric 30 is not implanted by the species. Typically, the section of the field dielectric 30 arranged on the lower portion 29 of the sidewall 16 of the trench 12 is not subjected to the implantation process.

The method described with reference to figures 4A to 4E may be used to fabricate a trench 12 having a field dielectric layer 30 which is arranged over the entire sidewall 16 but which has a thickness which varies in the vertical direction, that is varies in a direction that is perpendicular to the first major surface 13, for example which increases in a direction from the first major surface 13 to the base 15 of the trench 12. In some embodiments, method may be carried out such that the field dielectric 30 has a thickness which varies laterally, that is in at least one plane which is parallel to the first major surface 13. In some embodiments, the first section 41 of the initial field dielectric layer 30' that is implanted has a lateral extent that is less than the extent of the inner contour of the field dielectric 30. For example, if the trench 12 is a columnar trench having a circular lateral form, the initial field dielectric 30' also has a circular ring-shape and the species are implanted into a lateral arc section 41 of the ring that is less than the inner circumference of the initial field dielectric 30'.

A combination may be used so that the thickness of the field dielectric 30 is nonuniform the vertical z direction and also nonuniform in the lateral direction, i.e. in the x-y plane, as for example illustrated in figure 3.

Figure 4F illustrates a schematic view of a semiconductor wafer 100 and illustrates the possible orientation of the ion beam 101, which is used to implant the species into the field dielectric 30. The first major surface 13 of the wafer 100 is arranged in the xy plane, using the Cartesian coordinate system, and the z direction is orthogonal to the first major surface 13 and the x and y directions. The ion beam 101 is directed at the first major surface 13 and the orientation can be selected so as to include an angle of tilt with respect to the z axis and an angle of rotation with respect to the y axis or x axis.

For example, in order to form the four lobe structure of the field plate 17 illustrated in figure 3A, the ion beam 101 may be directed towards the first major surface 13 of the wafer 100 at four different rotational angles spaced apart by 90°. The tilt angle may be adjusted in order to adjust the depth from the first major surface 13 at which the ion beam hits the surface of the field dielectric 30 within the trench 12. Smaller tilt angles enable the ion beam 101 to hit the surface of the field dielectric 30 at a greater depth from the first major surface 13 and wider (larger) tilt angles enable the ion beam 101 to hit the surface of the field dielectric 30 at a smaller depth from the first major surface 13.

In order to increase the extent in the vertical z direction, of the region 41 which is implanted with the ions, an implantation may be carried out at two or more different tilt angles whilst the wafer 100 is at the same rotational angle.

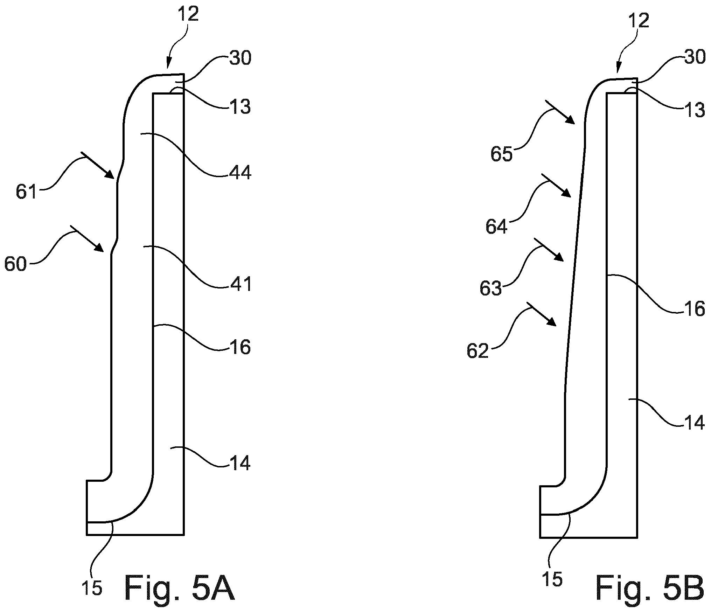

Figure 5A illustrates an example of a method in which an implantation of species, such as Ar ions, into the field dielectric 30 arranged on the side wall 16 of a trench 12 is carried out at two or more tilt angles. The trench 12 may be columnar or elongated. The implantation of species at two or more tilt angles may be carried out at one or more predetermined rotational angles. In this embodiment, the field dielectric 30 may also have a laterally varying thickness on the side wall 16 as shown in for example figure 3A in at least one plane, for example at the first major surface 13
In an embodiment, a first implantation is carried out at the first tilt angle as exemplified by the arrow 60 and the second implantation is carried out as the second tilt angle as exemplified by the arrow 61. The first tilt angle is smaller than the second tilt angle so that the first implantation region 41 of the field dielectric 30t is located at a greater depth from the first major surface 13 compared to the second region 44 into which the ions are implanted in the second implantation. In some embodiments, a single etching process is used have carrying out the first and second implantations. After a single etching process, a structured field dielectric 30 having two regions of differing thickness are formed on the side wall 16 in the vertical direction.

In some embodiments, more than two implantations may be carried out at different tilt angles followed by a single etch process to form a structured field dielectric having more than two regions of differing thickness on the side wall 16 of the trench.

In some embodiments, after the first implantation, a first etch process is carried out, then the second implantation and then a second etch process is carried out. The use of separate etch processes after each of two or more implantations may be used to form a field dielectric profile with more pronounced variations in thickness between adjacent regions of the field dielectric.

In an example, Ar ions may be implanted into the field dielectric 30' with a first dose of 1e15/cm² at an energy of 200keV and a tilt angle of 10° and then with a second dose 1e15/cm² at an energy of 300keV and a tilt angle of 20°. A single etch process is then carried out after the implantation processes have been completed. The etch rate of the lower region 41 implanted with the second dose is less than that of the etch rate of the upper region 44 implanted with the first dose. Consequently, after etching, the thickness of the field dielectric 30 remaining in the upper region is less than that the thickness of the field dielectric 30 remaining in the lower region of the side wall 16. In an example, after the etch process, the field dielectric 30 may have a thickness of 900 nm on the base 15 of the trench 12, a thickness of 940 nm on the lower section 29 of the side wall 16 and a thickness of 760nm on the upper section 27 of the side wall 16 of the trench 12.

In other embodiments, three or more different tilt angles may be used.

The method including multiple implants may be used to achieve a profile of the field dielectric 30 which monotonically increases from the first major surface 13 in a direction towards the base 15 of the trench 12, for example as shown in figure 1A, 3B or 5B. These methods may be used to fabricate a field dielectric 30 with a continuous taper such that the thickness continuously monotonically increases in a direction from the first major surface 13 towards the base 15 of the trench 12, as illustrated in figure 3B for example.

The implantation of species at multiple tilt angles may be carried out at one or more predetermined rotational angles. In this embodiment, the field dielectric 30 may also have a laterally varying thickness on the side wall 16 as shown in for example figure 3A in at least one plane, for example at the first major surface 13, and a vertically varying thickness as shown in figure 3B.

Figure 5B illustrates an example of a method in which four implants are carried out successively at the same angle of rotation to form a field dielectric with a continuous taper. The four implants are indicated schematically with the arrows 62, 63, 64, 65 in figure 5B. A first implant 62 of Ar ions with a dose of 1e16/cm² using an energy of 300keV at a tilt angle of 7°, a second implant 63 of Ar ions with a dose of 1e16/cm² using an energy of 300keV at a tilt angle of 10°, a third implant 64 of Ar ions with a dose of 1e16/cm² using an energy of 300keV at a tilt angle of 15°and a fourth implant 65 of Ar ions with a dose of 1e16/cm² using an energy of 300keV at a tilt angle of 20°. A single etch process is then performed. As an example, the thickness of the field dielectric on the side wall may increase from 530nm at the first major surface to 710nm at a depth of 5550 nm from the first major surface. The thickness on the base 15 of the trench 12 may be around 900 nm.

The implantation of species at four tilt angles may be carried out at one or more predetermined rotational angles. In this embodiment, the field dielectric 30 may also have a laterally varying thickness on the side wall 16 as shown in for example figure 3A in at least one plane, for example at the first major surface 13, and a vertically varying thickness as shown in figure 3B.

These methods including multiple implants into the field dielectric 30' on the side wall may be used to fabricate a field dielectric 30 with regions of differing thickness, whereby the thickness is substantially constant within each region, and which has a smooth edgeless transition between adjoining regions of differing thickness, e.g. as shown in figure 1B, 3C, 3D and 3E.

To summarize, a method of field dielectric structuring using damage implantation is provided. A field dielectric structure on the side wall of a trench 12 is provided which has smooth curved transitions between regions of differing thickness, i.e. edgeless boundaries. The performance of transistor devices including a field plate for charge compensation in a trench which has the complementary profile to that of such a structured field dielectric is improved.

Although the present disclosure is not so limited, the following numbered examples demonstrate one or more aspects of the disclosure.

### Examples

1. A semiconductor device comprising a transistor device, the transistor device comprising:
   one or more trenches formed in a first major surface of a semiconductor substrate, wherein each of the one or more trenches comprises:
   a base and a side wall extending from the base to the first major surface, wherein the side wall comprises an upper section, a lower section, and an intermediate section located between the lower section and the upper section,
   a field plate located in the trench, and
   a field dielectric that is located on the base and the sidewall of the trench and that has a surface;
   wherein, in the upper section of the sidewall, the field dielectric has a first thickness,
   wherein, in the lower section of the sidewall, the field dielectric has a second thickness that is greater than the first thickness,
      wherein, in the intermediate region of the sidewall, a thickness of the field dielectric changes from the first thickness at a first boundary between the upper section and the intermediate section to the second thickness at a second boundary between the lower section and the intermediate section,
   wherein the surface of the field dielectric has a concave form at the first boundary between the upper section and the intermediate section and a convex form at the second boundary between the lower section and the intermediate section, and
   wherein the second boundary is edgeless.
2. A semiconductor device according to example 1, wherein the concave form at the first boundary has a first radius of curvature of 100 nm to 500 nm.
3. A semiconductor device according to example 1 or example 2, wherein the convex form at the second boundary has a radius of curvature of 100 nm to 500 nm.
4. A semiconductor device according to any one of examples 1 to 3, wherein the trench has a depth d, wherein 500 nm ≤ d ≤ 20 µm.
5. A semiconductor device according to any one of examples 1 to 4, wherein an angle (α₂) is formed between the surface of the field dielectric in the intermediate section and in the lower section, wherein 180° < α₂ < 270° or 200° ≤ α₂ ≤ 250°
6. A semiconductor device according to any one of examples 1 to 5, wherein the angle α₂ is formed between a line at the point of the largest gradient of the surface of the field dielectric in the intermediate section and a line at the point of the largest gradient of the surface of the field dielectric in the lower section, wherein 180° < α₂ < 270° or 200° ≤ α₂ ≤ 250°
7. A semiconductor device according to any one of examples 1 to 6, wherein an angle α₁ is formed between the surface of the field dielectric in the upper section and in the intermediate section, wherein 90° < α₁ < 180° or 100° ≤ α₁ ≤ 150°
8. A semiconductor device according to any one of examples 1 to 7, wherein the angle α₁ is formed between a line at the point of the largest gradient of the surface of the field dielectric in the upper section and a line at the point of the largest gradient of the surface of the field dielectric in the intermediate section, wherein 90° < α₁ < 180° or 100° ≤ α₁ ≤ 150°
9. A semiconductor device according to any one of examples 1 to 8, wherein the first boundary is edgeless.
10. A semiconductor device according to any one of examples 1 to 9, wherein the first boundary is curved.
11. A semiconductor device according to any one of examples 1 to 10, wherein the first boundary has a radius of curvature.
12. A semiconductor device according to any one of examples 1 to 12, wherein a radius of curvature of **100 to 500 nm** is formed between the surface of the field dielectric in the intermediate section of the sidewall and the surface of the field dielectric in the lower section of the sidewall.
13. A semiconductor device according to any one of examples 1 to 12, wherein a radius of curvature of **100 to 500 nm** is formed between the surface of the field dielectric in the intermediate section of the sidewall and the surface of the field dielectric in the upper section of the sidewall.
14. A semiconductor device according to any one of examples 1 to 13, wherein the trench is a columnar trench and the field plate is a columnar field plate.
15. A semiconductor device according to example 14, wherein the columnar trench comprises a longitudinal axis and the first thickness of the field dielectric varies around the longitudinal axis in at least one plane that lies parallel to the first major surface.
16. A semiconductor device according to claim 15, wherein the second thickness of the field dielectric is substantially constant around the longitudinal axis in at least one plane that lies parallel to the first major surface.
17. A semiconductor device according to any one of examples 14 to 16,
   wherein a shape of the field plate is non-convex in at least one plane that lies parallel to the first major surface.
18. A semiconductor device according to any one of examples 14 to 17, wherein the columnar trench is circular in top view.
19. A semiconductor device according to any one of examples 14 to 18, wherein the columnar trench is circular in top view and the field dielectric has a thickness on the side wall of the columnar trench that is non-uniform in at least one plane that lies parallel to the first major surface.
20. A semiconductor device according to any one of examples 14 to 19, wherein the thickness of the field dielectric on the side wall of the columnar trench is nonuniform in a plane that is coplanar with the first major surface.
21. A semiconductor device according to any one of examples 1 to 20, wherein the difference between the first thickness and the second thickness is greater than 10%.
22. A semiconductor device according to any one of examples 14 to 21, wherein the columnar field plate has a width that varies angularly about the axis of rotation.
23. A semiconductor device according to any one of examples 14 to 22, wherein the thickness of the field dielectric varies between a minimum thickness tₘᵢₙ and a maximum thickness tₘₐₓ, wherein tₘₐₓ ≥ 1.1 tₘᵢₙ
24. A semiconductor device according to any one of examples 1 to 23, wherein in the upper section of the sidewall the field dielectric comprises ions of a noble gas or Ar ions and in the lower section of the sidewall the field dielectric on the side wall is free of ions of the noble gas or Ar ions, or
   in the upper section of the side wall the field dielectric has a concentration of Ar ions of 1e17cm⁻³ to1e19cm⁻³, e.g. 1e18cm⁻³ and in the lower section of the sidewall the field dielectric has a concentration of Ar ions of 1e14cm⁻³ to 1e16cm⁻³ , e.g. 1e15cm⁻³.
25. A semiconductor device according to any one of examples 1 to 24, wherein the semiconductor substrate has a first conductivity type, and mesas formed by the semiconductor substrate adjacent the columnar trenches comprise a drift region of the first conductivity type, a body region of a second conductivity type opposing the first conductivity type that is arranged on the drift region and a source region of the first conductivity type that is arranged on or in the body region.
26. A semiconductor device according to example 25, further comprising a gate trench formed in the first major surface of the mesas, wherein the gate trench comprises a gate electrode that is separated from the semiconductor substrate by a gate dielectric.
27. A method of fabricating a semiconductor device, the semiconductor device comprising:
   at least one trench in a first major surface of a semiconductor substrate, the at least one trench having a base and a side wall extending from the base to the first major surface, wherein the method comprises:
   forming a field dielectric over the base and side wall of the at least one trench,
   implanting species into a first section of the field dielectric arranged on the side wall,
   etching the field dielectric at least at the first section,
   inserting conductive material into the at least one trench to form a field plate.
28. A method according to example 27, wherein the etching the field dielectric at least at the first section comprises:
   forming the field dielectric with a first thickness in an upper section of the sidewall and with a second thickness in a lower section of the sidewall, the second thickness being greater than the first thickness, wherein, in an intermediate region of the sidewall that is arranged between the lower section and upper section, a thickness of the field dielectric changes from the first thickness at a first boundary between the upper section and the intermediate section to the second thickness at a second boundary between the lower section and the intermediate section, and
   wherein the second boundary is edgeless.
29. A method according to example 27 or example 28, wherein the first section has a height that is greater that the height of the field dielectric arranged on the side wall of the trench.
30. A method according to any one of examples 27 to 29, wherein the first section has a lateral extent that is less than the extent of the inner contour of the field dielectric.
31. A method according to any one of examples 27 to 30, wherein the trench is a columnar trench and the field plate is a columnar field plate.
32. A method according to example 31, wherein the columnar trench has a longitudinal axis and etching the field dielectric at least at the first section comprises forming a field dielectric having a thickness around the longitudinal axis which is nonuniform in at least one plane that lies parallel to the first major surface.
33. A method according to any one of examples 27 to 32, wherein etching the field dielectric at least at the first section comprises forming the field dielectric having the first thickness in an upper section of the side wall of the trench, the first thickness being non-uniform around the longitudinal axis in at least one plane that lies parallel to the first major surface.
34. A method according to any one of examples 27 to 33, wherein the species are Ar ions.
35. A method according to any one of examples 27 to 33, wherein the species are one or more of the group consisting of group 18 of the periodic table of elements, As ions, Ar ions, As, Pt, Ge, Kr and Xe.
36. A method according to any one of examples 27 to 35, wherein the species are implanted with a dosage of 1e13/cm2 to 1e17/cm2 and /or at an energy of 10keV to 1000keV.
37. A method according to any one of examples 27 to 36, wherein the method further comprises:
   at a first tilt angle with respect to the first major surface, implanting species into the first section of the field dielectric located on the side wall;
   at a second tilt angle with respect to the first major surface, implanting species into a second section of the field dielectric located on the side wall that vertically overlaps or borders the first section, wherein the second tilt angle is greater than the first tilt angle.
38. A method according to example 37, further comprising at a third tilt angle with respect to the first major surface, implanting species into a third section of the field dielectric located on the side wall that vertically overlaps or borders the second section, wherein the third tilt angle is greater than the second tilt angle.
39. A method according to any one of examples 27 to 38, further comprising depositing a field dielectric layer onto the field dielectric, then implanting the species, and after implanting the species, etching the field dielectric layer and the field dielectric.
40. A method according to any one of examples 27 to 39, wherein
   the thickness of the field dielectric decreases continuously/tapers in a direction from the base of the columnar trench towards the first major surface or
   the thickness of the field dielectric decreases discontinuously in a direction from the base of the columnar trench towards the first major surface and comprises at least one step.
41. A method according to any one of examples 31 to 40, wherein a plurality of columnar trenches is provided, the plurality of columnar trenches being arranged in a square grid array having a spacing d in directions x and y, which extend parallel to the first major surface and perpendicular to one another, and a spacing of dV2 in a direction of x ± 45° that extends parallel to the first major surface, wherein the species are implanted in the section of the field dielectric on the side wall at an orientation angle θ1 about the axis and θ1 is aligned with the direction x ± 45°.
42. A method according to example 41, further comprising implanting the species in a section of the field dielectric located on the side wall at an orientation angle θ2 about the axis, wherein θ2 = θ1 ± 45° and/or θ2 = θ1 ± 180°.
43. A method according to any one of examples 31 to 42, wherein in an upper portion of the columnar trenches, the field dielectric has a thickness t1 in the directions x and y and a thickness t2 in the diagonal direction x ± 45°, wherein t2 < t1.
44. A method according to any one of examples 27 to 43, wherein the semiconductor substrate has a first conductivity type, and mesas formed by the semiconductor substrate adjacent the columnar trenches comprise a drift region of the fist conductivity type, a body region of a second conductivity type opposing the first conductivity type that is arranged on the drift region and a source region of the first conductivity type that is arranged on or in the body region.
45. A method according to example 44, further comprising a gate trench formed in the first major surface of the mesas, wherein the gate trench comprises a gate electrode that is separated from the semiconductor substrate by a gate dielectric.
46. A semiconductor device, comprising a transistor device, the transistor device comprising:
   a plurality of columnar trenches formed in a first major surface of a semiconductor substrate, the columnar trench comprising a columnar field plate and a field dielectric located in the columnar trench,
   wherein the columnar trench comprises a base and a side wall extending from the base to the first major surface and the field dielectric is located on the base and side wall of the columnar trench,
   wherein the plurality of columnar trenches are arranged in a regular array having a centre-to-centre pitch p,
   wherein the field dielectric has a thickness d1 on the side wall of the columnar trench in lateral directions aligned with the centre-to-centre pitch p and a thickness d2 on the side wall of the columnar trench in lateral directions that are non-aligned with the centre-to-centre pitch p, wherein d2 < d1.
47. A semiconductor device according to example 46, wherein d1 and d2 lie in a common plane that is parallel to the first major surface, wherein (d1 - d2) is larger than processing variations.
48. A semiconductor device according to example 46 or example 47, wherein the columnar trenches each have a lateral square shape, or a lateral circular shape or a lateral hexagonal shape or a lateral octagonal shape.
49. A semiconductor device according to any one of examples 45 to 47,
   wherein the plurality of columnar trenches are arranged in a square grid array having a centre-to-centre pitch p in directions x and y, which extend parallel to the first major surface and perpendicular to one another, and a spacing of pV2 in a direction of x ± 45° that extends parallel to the first major surface,
   wherein the field dielectric has the thickness d1 on the side wall of the trench in the lateral directions x and y and the thickness d2 on the side wall of the trench in the direction x ± 45°.
50. A semiconductor device according to example 49, wherein the columnar trenches each have a lateral square shape and the corners of the lateral square shape are located in the x ± 45 directions.
51. A semiconductor device according to any one of examples 45 to 50, wherein the plurality of columnar trenches are arranged in a hexagonal grid array having a centre-to-centre pitch p in directions a and b, which extend parallel to the first major surface and at 60° to one another, wherein the field dielectric has the thickness d1 on the side wall of the trench in the lateral directions a and b and the thickness d2 on the side wall of the trench in the direction x ± 30°.
52. A semiconductor device, comprising:
   a plurality of columnar trenches formed in a first major surface of a semiconductor substrate, the columnar trench comprising a columnar field plate and a field dielectric located in the columnar trench,
   wherein the columnar trench comprises a base and a side wall extending from the base to the first major surface and the field dielectric is located on the base and side wall of the columnar trench,
   wherein the plurality of columnar trenches are arranged in a square grid array having a spacing d in directions x and y, which extend parallel to the first major surface and perpendicular to one another, and a spacing of dV2 in a direction of x ± 45° that extends parallel to the first major surface,
   wherein the field dielectric has a thickness d1 on the side wall of the trench in the lateral directions x and y and a thickness d2 on the side wall of the trench in the direction x ± 45°, wherein d2 < d1, wherein (d1 - d2) is larger than processing variations.
53. A semiconductor device according to example 52, wherein the field dielectric has the thickness d1 and the thickness d2 in a plane that is coplanar with the first major surface.
54. A semiconductor device according to example 52 or example 53, wherein the columnar trench has an axis of rotation that extends perpendicularly to the first major surface and the thickness of the field dielectric on the side wall varies angularly about the axis of rotation.
55. A semiconductor device according to example 54, wherein the columnar field plate has a width that varies angularly about the axis of rotation.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A method of fabricating a semiconductor device, the semiconductor device comprising:
at least one trench in a first major surface of a semiconductor substrate, the at least one trench having a base and a side wall extending from the base to the first major surface, wherein the method comprises:
forming a field dielectric over the base and side wall of the at least one trench,
implanting species into a first section of the field dielectric arranged on the side wall,
etching the field dielectric at least at the first section,
inserting conductive material into the at least one trench to form a field plate.

2. A method according to claim 1, wherein the etching the field dielectric at least at the first section comprises:
forming the field dielectric with a first thickness in an upper section of the sidewall and with a second thickness in a lower section of the sidewall, the second thickness being greater than the first thickness, wherein, in an intermediate region of the sidewall that is arranged between the lower section and upper section, a thickness of the field dielectric changes from the first thickness at a first boundary between the upper section and the intermediate section to the second thickness at a second boundary between the lower section and the intermediate section, and
wherein the second boundary is edgeless.

3. A method according to claim 1 or claim 2, wherein the first section has a height that is greater than the height of the field dielectric arranged on the side wall of the trench.

4. A method according to any one of claims 1 to 3, wherein the trench is a columnar trench and the field plate is a columnar field plate.

5. A method according to claim 4, wherein the columnar trench has a longitudinal axis and etching the field dielectric at least at the first section comprises forming a field dielectric having a thickness around the longitudinal axis which is non-uniform in at least one plane that lies parallel to the first major surface.

6. A method according to any one of claims 1 to 5, wherein the species comprise one or more of the group consisting of group 18 of the periodic table of elements, As ions, Ar ions, Pt, Ge, Kr and Xe.

7. A method according to any one of claims 1 to 6, the method further comprising:
at a first tilt angle with respect to the first major surface, implanting species into the first section of the field dielectric located on the side wall;
at a second tilt angle with respect to the first major surface, implanting species into a second section of the field dielectric located on the side wall that vertically overlaps or borders the first section, wherein the second tilt angle is greater than the first tilt angle.

8. A method according to any one of claims 1 to 7, further comprising:
at a first rotational angle with respect to an axis perpendicular to the first major surface, implanting species into a first section of the field dielectric located on the side wall;
at a second rotational angle with respect to the axis, implanting species into a second section of the field dielectric located on the side wall, wherein the second rotational angle differs from the first rotational angle.

9. A semiconductor device comprising a transistor device, the transistor device comprising:
one or more trenches formed in a first major surface of a semiconductor substrate, wherein each of the one or more trenches comprises:
a base and a side wall extending from the base to the first major surface, wherein the side wall comprises an upper section, a lower section, and an intermediate section located between the lower section and the upper section,
a field plate located in the trench, and
a field dielectric that is located on the base and the sidewall of the trench and that has a surface;
wherein, in the upper section of the sidewall, the field dielectric has a first thickness,
wherein, in the lower section of the sidewall, the field dielectric has a second thickness that is greater than the first thickness,
wherein, in the intermediate region of the sidewall, a thickness of the field dielectric changes from the first thickness at a first boundary between the upper section and the intermediate section to the second thickness at a second boundary between the lower section and the intermediate section,
wherein the surface of the field dielectric has a concave form at the first boundary between the upper section and the intermediate section and a convex form at the second boundary between the lower section and the intermediate section, and
wherein the second boundary is edgeless.

10. A semiconductor device according to claim 9, wherein the concave form at the first boundary has a first radius of curvature of 100 nm to 500 nm.

11. A semiconductor device according to claim 9 or claim 10, wherein the convex form at the second boundary has a second radius of curvature of 100 nm to 500 nm

12. A semiconductor device according to any one of claims 9 to 11, wherein the trench is a columnar trench and the field plate is a columnar field plate.

13. A semiconductor device according to claim 12, wherein the columnar trench comprises a longitudinal axis and the first thickness of the field dielectric varies around the longitudinal axis in at least one plane that lies parallel to the first major surface.

14. A semiconductor device according to claim 13, wherein the second thickness of the field dielectric is substantially constant around the longitudinal axis in at least one plane that lies parallel to the first major surface.

15. A semiconductor device according to any one of claims 9 to 13, wherein the columnar trench comprises a longitudinal axis and the second thickness of the field dielectric varies around the longitudinal axis in at least one plane that lies parallel to the first major surface.

16. A semiconductor device comprising a transistor device, the transistor device comprising:
a plurality of columnar trenches formed in a first major surface of a semiconductor substrate, the columnar trench comprising a columnar field plate and a field dielectric located in the columnar trench,
wherein the columnar trench comprises a base and a side wall extending from the base to the first major surface and the field dielectric is located on the base and side wall of the columnar trench,
wherein the plurality of columnar trenches are arranged in a regular array having a centre-to-centre pitch p,
wherein the field dielectric has a thickness d1 on the side wall of the columnar trench in lateral directions aligned with the centre-to-centre pitch p and a thickness d2 on the side wall of the columnar trench in lateral directions that are non-aligned with the centre-to-centre pitch p, wherein d2 < d1 and (d1-d2) is larger than processing variations).

## Amended claims

### Amended claims in accordance with Rule 137(2) EPC.

1. A method of fabricating a semiconductor device (10), the semiconductor device comprising: at least one trench (12) in a first major surface (13) of a semiconductor substrate (14), the at least one trench having a base (15) and a side wall (16) extending from the base to the first major surface, wherein the method comprises:
forming a field dielectric (30) over the base and side wall of the at least one trench;
implanting species into a first section (41) of the field dielectric arranged on the side wall;
etching the field dielectric at least at the first section; and
inserting conductive material into the at least one trench to form a field plate (17),.

2. The method according to claim 1, wherein the etching the field dielectric (30) at least at the first section comprises:
forming the field dielectric with a first thickness (t1) in an upper section (27) of the sidewall and with a second thickness (t2) in a lower section (29) of the sidewall, the second thickness being greater than the first thickness, wherein, in an intermediate region (28) of the sidewall that is arranged between the lower section and upper section, a thickness of the field dielectric changes from the first thickness at a first boundary between the upper section and the intermediate section to the second thickness at a second boundary between the lower section and the intermediate section, and
wherein the second boundary is edgeless.

3. The method according to claim 1 or 2, wherein the at least one trench (12) is a columnar trench and the field plate (17) is a columnar field plate.

4. The method according to claim 3, wherein the columnar trench has a longitudinal axis and etching the field dielectric at least at the first section comprises forming a field dielectric having a thickness around the longitudinal axis which is non-uniform in at least one plane that lies parallel to the first major surface.

5. The method according to any one of claims 1 to 4, wherein the species comprise one or more of the group consisting of group 18 of the periodic table of elements, As ions, Ar ions, Pt, Ge, Kr and Xe.

6. The method according to any one of claims 1 to 5, the method further comprising:
at a first tilt angle with respect to the first major surface, implanting species into the first section of the field dielectric located on the side wall;
at a second tilt angle with respect to the first major surface, implanting species into a second section of the field dielectric located on the side wall that vertically overlaps or borders the first section, wherein the second tilt angle is greater than the first tilt angle.

7. The method according to any one of claims 1 to 6, further comprising:
at a first rotational angle with respect to an axis perpendicular to the first major surface, implanting species into a first section of the field dielectric located on the side wall;
at a second rotational angle with respect to the axis, implanting species into a second section of the field dielectric located on the side wall, wherein the second rotational angle differs from the first rotational angle.
